# EUROPÄISCHE PATENTSCHRIFT

(11) **EP 1 655 837 B1**
(45) Veröffentlichungstag und Bekanntmachung des Hinweises auf die Patenterteilung: **22.07.2015**
(21) Anmeldenummer: 05021076.4
(22) Anmeldetag: 27.09.2005
(51) Int. Cl.: H03H 9/64

(54) **Umschaltbares SAW Filter, Filter-Vorrichtung mit dem SAW Filter und Verfahren zum Betreiben des SAW Filters**
Switchable SAW filter, SAW-filter device and method of operating the same
Filtre à ondes acoustiques de surface, dispositif de filtre à ondes acoustiques de surface et son procédé de fonctionnement

(30) Priorität: 09.11.2004 DE 102004054081
(43) Veröffentlichungstag der Anmeldung: 10.05.2006
(73) Patentinhaber: EPCOS AG, 81669 München (DE)
(72) Erfinder: Bergmann, Andreas, 84533 Haiming (DE); Glas, Alexander, 81738 München (DE); Kloska, Gerhard, 83022 Rosenheim (DE)
(74) Vertreter: Epping - Hermann - Fischer

(56) Entgegenhaltungen:
- US-A- 4 480 237
- US-A- 4 604 595
- US-A- 4 954 795
- FISCHERAUER A ET AL: "Design of switchable inline filters and compensation of second order effects" ULTRASONICS SYMPOSIUM, 1992. PROCEEDINGS., IEEE 1992 TUCSON, AZ, USA 20-23 OCT. 1992, NEW YORK, NY, USA,IEEE, US, 20. Oktober 1992 (1992-10-20), Seiten 15-18, XP010103611 ISBN: 0-7803-0562-0
- C.K CAMPBELL: "Surface Acoustic Wave Devices for Mobile and Wireless Communications" 15. Juni 1998 (1998-06-15), ACADEMIC PRESS , US, SAN DIEGO , XP002367375 * Seite 76, Absatz 3.4 - Seite 87, Absatz 3.5.3; Abbildungen 3.9-3.13 *

## Beschreibung

In Fernsehempfangsgeräten sind meist als Bandpassfilter ausgebildete SAW Filter enthalten, die aus einem vom Tuner gelieferten, auf eine Zwischenfrequenz umgesetzten Ausgangssignal den Kanal für ein gewünschtes Programm herausfiltern. In Abhängigkeit vom Frequenzband können die gesuchten bzw. gewünschten Kanäle unterschiedliche Bandbreiten aufweisen, beispielsweise 7 MHz Bandbreite für VHF und 8 MHz für UHF. Neben diesen in Deutschland verwendeten Bändern existieren in anderen Ländern weitere Standards, die davon verschiedene Bandbreiten besitzen können.

In einem Fernsehempfangsgerät, das solche Standards mit unterschiedlichen Bandbreiten bedienen kann, ist üblicherweise für jede verlangte Bandbreite ein eigenes SAW Bandpassfilter erforderlich, das die Bandbreite aufweist.

Es sind auch SAW Filter bekannt geworden, die einen veränderbaren Durchlassbereich aufweisen. Bei diesen SAW Filtern kann zwischen zwei unterschiedlichen Übertragungsfunktionen dadurch umgeschaltet werden, indem einer der drei Anschlüsse des SAW Bandpassfilters wahlweise mit einem der an den beiden anderen Anschlüssen liegenden Potenziale verbunden wird. Üblicherweise sind dies Masse und ein von Masse verschiedenes Potenzial, welches im Folgenden als "heiß" bezeichnet wird. Zum Betrieb dieses Filters ist ein zusätzlicher Schaltkreis erforderlich, der den Schaltpin des Filters zwischen Masse und dem heißen Potenzial umschalten kann.

Ein solches Filter ist beispielsweise aus der US 5,867,075A bekannt. Dort wird ein Filter beschrieben, bei dem durch die genannte Umschaltung zusätzliche Überlappungsbereiche aktiviert werden können, die im anderen Schaltungszustand kurzgeschlossen bzw. beide auf Masse gelegt sind.

Die Umschaltung wird üblicherweise durch ein aus diskreten Komponenten aufgebautes Umschaltnetzwerk bewerkstelligt und über eine Steuerleitung vom Tuner-IC aus angesteuert. Eine Integration dieses externen Schaltnetzwerks, welches Widerstände für das Biasing, eine PIN-Diode und Schalttransistoren umfasst, in den IC des Tuners hinein ist zwar theoretisch möglich, jedoch mit Problemen verbunden. Die Eingangsmasse des SAW Filters, der zum Schalten benötigt wird, wird auf diese Weise in den integrierten Schaltkreis hinein verlagert, was zu einer Masseschleife führen und die Selektion verschlechtern kann. Außerdem beschränkt sich der Einsatz eines solchen IC auf SAW Filter mit unsymmetrischer Speisung.

Aus dem Artikel "Design of Switchable Inline Filters and Compensation of Second Order Effects" von A. Fischerauer und W. Schott in Proceedings of Ultrasonics Symposium 1992, Seiten 15-18 ist ein schaltbares SAW Filter mit zwei akustischen Teilspuren bekannt, bei dem eine erste Übertragungsfunktionen durch eine erste Teilspur und eine zweite Übertragungsfunktion dagegen durch Parallelverschalten der beiden Teilspuren erzeugt wird.

Aus der US 4,954,795 A ist eine schaltbare Filteranordnung mit zwei Übertragungsfunktionen bekannt, wobei zwischen zwei einzelnen Filtern hin- und hergeschaltet wird. Aus der US 4,604,595 A ist es bekannt, eine Übertragungsfunktion durch parallele Verschaltung zweier Teilwandler zu realisieren. Aus der US 4,480,237 A ist es bekannt, eine Übertragungsfunktion durch parallele Verschaltung zweier Teilwandler zu realisieren, wobei mit Hilfe einer Gainschaltung die Amplitude des von einem der Teilwandler gelieferten Signals zu variieren, so dass der Amplitudenanteil des einen Teilwandlers am Gesamtsignal bei gleichbleibender Phasenbeziehung verändert werden kann.

Aufgabe der vorliegenden Erfindung ist es daher, ein schaltbares SAW Filter für zwei unterschiedliche Übertragungsfunktionen anzugeben, welches die genannten Nachteile vermeidet.

Diese Aufgabe wird erfindungsgemäß durch ein Filter mit den Merkmalen von Anspruch 1 gelöst. Vorteilhafte Ausgestaltungen der Erfindung sowie eine Filtervorrichtung mit dem Filter und ein Verfahren zum Betreiben des Filters sind weiteren Ansprüchen zu entnehmen.

Ein erfindungsgemäßes SAW Filter weist einen gewichteten Eingangswandler auf, der eine erste und eine zweite akustische Teilspur umfasst. Das Filter bietet nun die Möglichkeit, zur parallelen oder antiparallelen Verschaltung der beiden Teilspuren. Jeder der beiden Verschaltungszustände realisiert eine der beiden Übertragungsfunktionen.

Das Filter weist Schaltmittel auf, die die beiden Teilspuren wahlweise parallel oder antiparallel verschalten können, wobei durch die beiden unterschiedlichen Verschaltungen der beiden Teilspuren eine erste und eine zweite Übertragungsfunktion realisiert werden.

Die Verschaltung der beiden Teilspuren kann über die Ansteuerung durch den Tuner-IC erfolgen, indem die beiden Teilspuren tunerseitig mit dem entsprechenden Signal versorgt werden.

Das erfindungsgemäße Filter hat den Vorteil, dass nun das externe Schaltnetzwerk entfällt und die zum Umschalten erforderlichen Komponenten vollständig in den Tuner-IC integriert werden können. Beim erfindungsgemäßen Filter sind im Eingangswandler in beiden Schaltungszuständen sämtliche Überlappungen aktiv, so dass an den heißen Pins unabhängig vom Schaltungszustand immer die gleiche Impedanz gemessen wird. Es ist daher beim Umschalten keine Impedanzanpassung erforderlich. Die beiden gewünschten Übertragungsfunktionen werden erhalten, indem die Anregungsfunktionen, die in jeder Teilspur realisiert sind, durch entsprechende parallele oder antiparallele Verschaltung der beiden Teilspuren additiv oder subtraktiv zu einem Gesamtsignal vereinigt werden. Gegenüber herkömmlichen schaltbaren SAW Filtern, deren beide Schaltungszustände sich bezüglich der Eingangsimpedanz wesentlich stärker unterscheiden, hat dies von der schaltungstechnischen Umgebung und von der Qualität der dadurch möglichen optimalen Anpassung her erhebliche Vorteile.

Zum Ansteuern eines erfindungsgemäßen SAW Filters sind tunerseitig nur wenige Komponenten erforderlich. Die beiden Teilspuren des Eingangswandlers werden im zweiten Schaltungszustand mit einem vom Tuner gelieferten unsymmetrischen Signal verbunden (Gleichtaktbetrieb) und beide Teilspuren parallel gegen Masse geschaltet. Der erste Schaltungszustand ergibt sich durch ein vom Tuner geliefertes differenzielles Signal (Gegentaktbetrieb), wobei jede der beiden Teilspuren mit einem der beiden differenziellen Potenziale verbunden und jeweils gegen Masse geschaltet wird. Da die beiden differenziellen im Gegentakt anliegenden Potenziale die gleiche Amplitude, aber entgegengesetzte bzw. um 180° verschiedenen Phasen aufweisen, entspricht diese Verschaltung einer antiparallelen Verschaltung der beiden Teilspuren.

Da bekannte Fernsehtuner üblicherweise bereits ein differenzielles symmetrisches Signal liefern können, ist zum Ansteuern eines erfindungsgemäßen SAW Filters lediglich ein weiterer Emitter-Folger in den Tuner-IC zu integrieren, der ein zum ersten Emitter-Folger phasengleiches Signal erzeugt. Auf diese Weise kann im Tuner auf den zweiten Ausgang entweder das differenzielle oder das phasengleiche Ausgangssignal geschaltet werden. Der Steuerausgang und das externe Schaltnetzwerk des bekannten umschaltbaren SAW Filters entfallen somit.

Ein vollständiges Filter umfasst neben dem Eingangswandler noch einen Ausgangswandler, der die vom Eingangswandler produzierte akustische Welle wieder in ein elektrisches Signal umwandelt. Die Apertur des Ausgangswandlers umfasst daher zumindest die Summe der beiden Teilaperturen der Teilwandler.

Die beiden Teilspuren können in einem einzigen Wandler verwirklicht sein, der eine mittlere dritte Stromschiene aufweist. Diese Ausführung hat den Vorteil, dass das Filter nur drei Anschlüsse für den Eingangswandler erfordert, wobei die mittlere Stromschiene dann stets mit dem Massepotenzial verbunden wird. Die beiden äußeren Stromschienen werden im ersten Schaltungszustand für die erste Übertragungsfunktion mit dem differenziellen Signal belegt, wodurch die beiden Teilspuren antiparallel verschaltet werden (Gegentaktbetrieb). Im zweiten Schaltungszustand mit der zweiten Übertragungsfunktion werden die beiden äußeren Stromschienen mit dem gleichen unsymmetrischen Ausgangssignal verbunden und daher beide parallel unsymmetrisch geschaltet (Gleichtaktbetrieb).

In einer Ausgestaltung weist der Eingangswandler eine Split-Finger-Anordnung auf. Diese ermöglicht Anregungen im λ/4 Raster, die bei TV Filtern zum Realisieren unsymmetrischer Anregungsfunktionen erforderlich sind. Außerdem können sich dabei interne Reflexionen an den Fingern gegenseitig auslöschen. Ein solches Filter mit einer solchen Finger-Anordnung besitzt eine Übertragungsfunktion mit einem besonders flach ausgebildeten Passband.

Im erfindungsgemäßen Eingangswandler wird die Anregungsfunktion vorzugsweise durch Überlappungswichtung realisiert. Dabei sind vorzugsweise in der Mitte des Wandlers die größeren Überlappungen, an den beiden Enden des Wandlers dagegen nur kleine Überlappungen und damit kleinere Beiträge zur Anregungsfunktion vorgenommen. Vorteilhaft ist an dem zum Ausgangswandler gerichteten Ende des Eingangswandlers der längere Elektrodenfinger in jeder Teilspur mit dem Massepotenzial verbunden. Noch vorteilhafter enden die Elektrodenfinger am ausgangsseitigen Ende des Eingangswandlers in der Nähe der mit dem jeweils heißen Potenzial verbundenen Stromschiene. Dies hat den Vorteil, dass sich zwischen Eingangs- und Ausgangswandler nur geringe parasitäre Kapazitäten ausbilden und ein Übersprechen zwischen dem heißen Potenzial des Eingangswandlers und dem Ausgangswandler minimiert wird.

In weiterer vorteilhafter Ausgestaltung sind die kurzen Überlappungen am entgegengesetzten Ende des Eingangswandlers in der Nähe der jeweils mit dem Masse-Potenzial verbundenen Stromschiene angeordnet. Auf diese Weise ist das Überlappungsgebiet innerhalb jeder Teilspur im Wesentlichen spindelförmig ausgebildet und schräg in der jeweiligen Teilspur angeordnet.

Demgegenüber ist der Ausgangswandler meist als ungewichteter Normalfingerwandler ausgebildet. Möglich ist es jedoch auch, den Ausgangswandler als Split-Finger-Wandler auszuführen. Insgesamt ist der Ausgangswandler wesentlich kürzer ausgebildet als der Eingangswandler und weist daher eine geringere Anzahl von Elektrodenfingern auf.

Zwischen Ein- und Ausgangswandler kann eine Abschirmstruktur vorgesehen sein, die ebenfalls das Übersprechen zwischen Ein- und Ausgang verhindert. Eine solche Abschirmstruktur kann als Metallisierungsstreifen ausgeführt sein, der schräg über beide Teilaperturen verläuft und vorzugsweise eine größere Breite als die einzelnen Elektrodenfinger des Eingangswandlers aufweist.

In einer weiteren Ausgestaltung der Erfindung wird in beiden Teilspuren ausgangseitig der Abstand der beiden Stromschienen zueinander reduziert. Dadurch werden kürzere endständige Elektrodenfinger erzeugt, die für eine kontinuierlichere Ladungsverteilung sorgen. Vorzugsweise wird der Abstand der beiden Stromschienen durch ein stufenförmige Verringerung der jeweiligen Apertur erzeugt, die sowohl von der mittleren Stromschiene als auch von jeder der beiden äußeren Stromschienen ausgehen kann. Der Abschnitt verringerten Abstands zwischen den beiden Stromschienen jeder Teilapertur kann sich über zwei bis vier endständige Finger erstrecken. Eine vorteilhafte Anwendung findet ein erfindungsgemäßes Filter bei in Europa eingesetzten Übertragungsstandards zur Umschaltung zwischen UHF-Band und VHF-Band.

Ein erfindungsgemäßes Filter ist vorteilhaft mit einem Tuner verbunden, der die entsprechenden Mittel zum Betreiben des erfindungsgemäßen Filters aufweist. Eine erfindungsgemäße Filtervorrichtung mit einem Tuner umfasst daher ein erfindungsgemäßes SAW Filter, eine Eingangsstufe, die ausgebildet ist zum Empfang eines ungefilterten Eingangssignals, einen Mischer, der das Eingangssignal auf eine Zwischenfrequenz umsetzt, eine Verstärkerstufe, die als Treiber für das SAW Filter ausgebildet ist und sowohl ein differenzielles symmetrisches Ausgangssignal als auch ein unsymmetrisches Ausgangssignal liefern kann sowie Schaltmittel, die die beiden Teilspuren des SAW Filters wahlweise parallel mit dem unsymmetrischen Ausgangssignal oder antiparallel so schalten können, dass jede Teilspur mit jeweils einem Teilpotenzial des differenziellen Ausgangssignals gegen Masse geschaltet ist. Dabei ist es ohne Belang, ob das Eingangssignal von einem Übertragungskabel oder von einer Antenne geliefert wird.

Je nachdem, wie weit die gewünschten Kanäle über das Frequenzband verteilt sind, kann auch eingangsseitig eine Filterbank vorgeschaltet sein, die das Eingangssignal in eine Mehrzahl von Signalpfaden, beispielsweise in drei Signalpfade, aufsplittet. Jedem dieser Signalpfade kann dann ein eigener Mischer zugeordnet sein, wobei die Ausgangsseite aller Mischer an einem Punkt vereinigt sind und dem SAW-Treiber, also der Verstärkerstufe, zugeschaltet werden. Es ist auch möglich, einen gemeinsamen Mixer für alle Pfade zu verwenden. Möglich ist es auch, dass die Mixer der Pfade mit getrennten SAW Treibern (Verstärkern) verschaltet werden, die dann auch verschiedene SAW Filter treiben können, um z.B. digitale und analoge Empfangssignale getrennt zu behandeln. Zumindest eines der Filter, vorteilhaft jedoch alle, ist dann erfindungsgemäß ausgebildet.

Die Verstärkerstufe weist typischerweise zwei Emitterfolger als Ausgänge auf, wobei ein dritter Ausgang mit dem Massepotenzial verbunden ist. Es sind aber auch andere Verstärkerstrukturen am Ausgang möglich. Die zwei Emitterfolger sind entweder mit einem phasen- und amplitudengleichen unsymmetrischen Ausgangssignal oder mit einem differenziellen symmetrischen Ausgangssignal belegt. Die unterschiedliche Belegung wird über die genannten Schaltmittel gesteuert. Die Verstärkerstufe ist so ausgebildet, dass sie das SAW Filter insbesondere niederohmig betreiben kann.

Der Ausgang der Verstärkerstufe ist vorzugsweise so ausgebildet, dass er unterschiedliche Lasten sowohl im Gleich- als auch im Gegentaktbetrieb (bei symmetrischem bzw. unsymmetrischem Ausgangssignal) mit ausreichenden Strömen treiben kann. Die Verstärkerstufe ist weiterhin so ausgebildet, dass sie auch leicht unterschiedliche Eingangsimpedanzen des Filters sowohl im Gleich- als auch im Gegentaktbetrieb betreiben kann. Vorteilhaft sind Verstärkerstufe und Schaltmittel auf einem IC integriert.

Im Folgenden wird die Erfindung anhand von Ausführungsbeispielen und den dazugehörigen Figuren näher erläutert. So weit das Filter oder die Anordnung mit dem Filter dargestellt ist, sind die Figuren nur schematisch ausgeführt und dienen allein zur Veranschaulichung der Erfindung. Gleiche Teile sind mit gleichen Bezugszeichen bezeichnet.
Figur 1 zeigt in schematischer Darstellung ein erstes Ausführungsbeispiel eines Filters,
Figur 2 zeigt ein zweites Ausführungsbeispiel eines Filters,
Figur 3 zeigt schematisch ein drittes Ausführungsbeispiel eines Filters,
Figur 4 zeigt die Übertragungsfunktionen dieses Filters,
Figur 5 zeigt die Transmittanz der Teilspuren dieses Filters,
Figur 6 zeigt die Impulsantwort der Teilspuren und des Filters,
Figur 7 zeigt die Übertragungsfunktion eines weiteren Ausführungsbeispiels,
Figur 8 zeigt die Transmittanz Y21 zweier Teilspuren,
Figur 9 zeigt die Impulsantwort von den Teilspuren und dem Gesamtfilter des weiteren Ausführungsbeispiels,
Figur 10 zeigt in schematischer Darstellung einen möglichen Tuneraufbau.

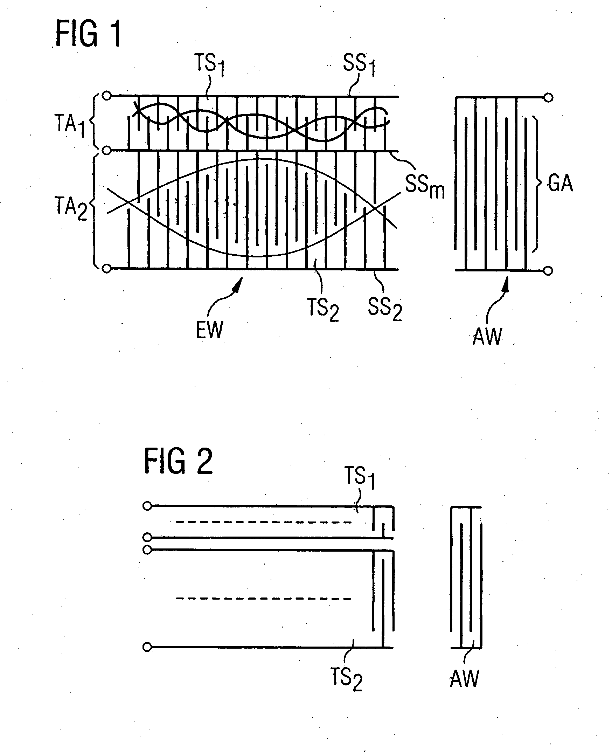

Figur 1 zeigt die schematische Darstellung eines erfindungsgemäßen Filters, der aus einem Eingangswandler EW und einem Ausgangswandler AW besteht. Der Eingangswandler EW ist in eine erste Teilspur TS1 und eine zweite Teilspur TS2 aufgeteilt. Die beiden Teilspuren nutzen eine gemeinsame mittlere Stromschiene SS_{M}, während die beiden äußeren Stromschienen als SS1 und SS2 bezeichnet sind. Jede der Teilspuren TS1, TS2 weist gewichtete Elektrodenfinger auf, die hier mit Überlappwichtung dargestellt sind. Über die Wichtung ist in jeder Teilspur eine Anregungsfunktion AF1, AF2 realisiert. Es sind jedoch auch weitere Wichtungsmethoden einsetzbar, insbesondere eine Serienwichtung, bei der Eingangswandler quer zur Ausbreitungsrichtung der Welle in elektrisch in Serie geschaltete Teilbereiche aufgeteilt ist, die dann auf Zwischenpotential liegen.

Der Ausgangswandler AW besitzt eine Apertur A, die zumindest der Summe der Teilaperturen TA1, TA2 der beiden Teilspuren TS entspricht.

Der Ausgangswandler ist typischerweise ungewichtet und vorzugsweise als Normalfingerwandler ausgebildet. Möglich ist es aber auch, den Ausgangswandler zu wichten. Der Ausgangswandler kann aberauch Splitfinger aufweisen oder SPUDT-Zellen enthalten.

Die Anregungsfunktionen innerhalb der beiden Teilspuren sind so ausgebildet, dass sich durch additive bzw. subtraktive Überlagerung der beiden Anregungsfunktionen zwei unterschiedliche Übertragungsfunktionen ergeben, mit denen das Filter für unterschiedliche Übertragungsstandards eingesetzt werden kann. Beispielsweise können sich die beiden Übertragungsfunktionen in der Bandbreite unterscheiden. Möglich ist es jedoch auch, mit Hilfe eines erfindungsgemäßen Filters zwei Übertragungsfunktionen zu realisieren, die sich in weiteren Eigenschaften und insbesondere der Form des Passbands unterscheiden. Möglich ist es z. B., die Übertragungsfunktionen an unterschiedliche Übertragungsstandards anzupassen, beispielsweise was die Bandbreite der Tontreppe eines Intercarrier-Filters betrifft.

Die in der Figur dargestellten, durch die Überlappung der Elektrodenfinger realisierten Anregungsfunktionen sind hier nur schematisch angedeutet, mit einer Hüllkurve verdeutlicht und weisen im realen Fall einen wesentlich komplexeren Aufbau auf. Die überlappenden Elektrodenfinger können an der jeweils gegenüberliegenden Stromschiene auf jeweils gleicher longitudinaler Position jeweils noch einen entsprechenden Stummelfinger aufweisen, damit innerhalb der Teilspuren eine möglichst gleichmäßige Metallisierung vorhanden ist.

Die hier gemeinsame mittlere Stromschiene SSₘ und die beiden äußeren Stromschienen SS1 und SS2 sind mit den drei Anschlüsse des Eingangswandlers EW verbunden, während der Ausgangswandler über seine beiden Stromschienen und damit verbundene Anschlusspads zwei Ausgänge aufweist.

Figur 2 zeigt eine weitere mögliche Ausführungsform eines erfindungsgemäßen Filters, bei dem die beiden Teilspuren TS1, TS2 in Form von zwei separaten Wandlern verwirklicht sind. Die hier nur angedeuteten Elektrodenfinger verwirklichen, wie in Figur 1, in jeder Teilspur TS1, TS2 jeweils eine unabhängige Anregungsfunktion, aus der sich durch additive oder subtraktive Überlagerung die zwei gewünschten Übertragungsfunktionen des Filters ergeben. Der Ausgangswandler ist in diesem Ausführungsbeispiel mit großer, über beide Teilwandler reichende Apertur ausgeführt. Möglich ist es jedoch auch, den Ausgangswandler in Form zweier verschalteter Teilwandler mit entsprechend kleinerer Apertur auszuführen.

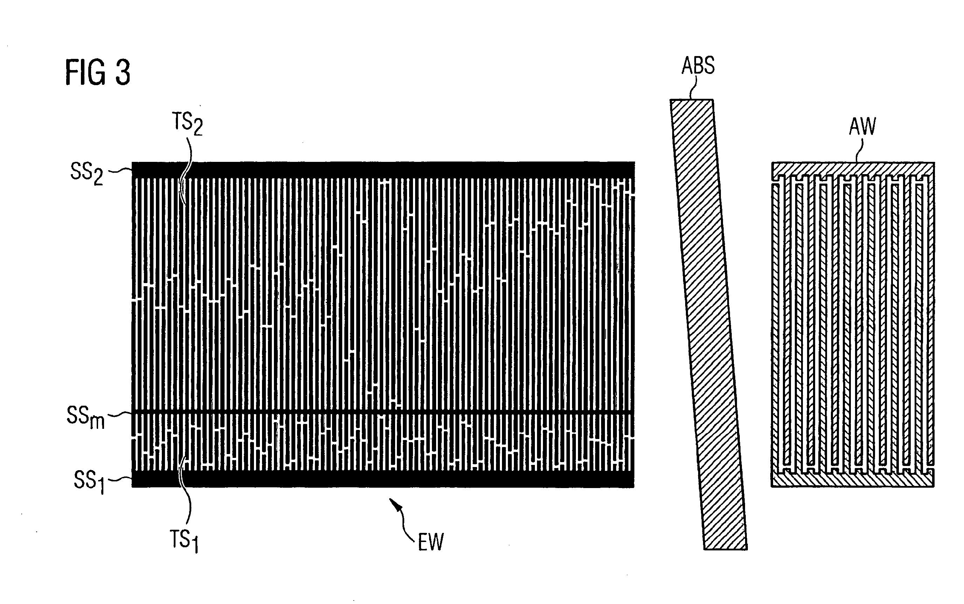

Figur 3 zeigt ein der Realität weiter angenähertes Design eines erfindungsgemäßen Filters. Als weitere Struktur weist dieses Filter eine Abschirmstruktur ABS auf, die in Form eines schräg zur Ausbreitungsrichtung der Oberflächenwelle angeordneten Metallisierungsstreifens realisiert ist. Die beiden Teilspuren TS1, TS2 weisen eine gemeinsame mittlere Stromschiene SSₘ auf und bilden den Eingangswandler EW. Es ist eine Split-Finger-Anordnung ausgewählt, die für den Wandler vorteilhaft, aber nicht unbedingt erforderlich ist. Dabei gehen jeweils zwei benachbarte Finger von der gleichen Stromschiene aus. Pro Wellenlänge enthält eine Split-Finger-Anordnung daher vier Elektrodenfinger.

Im dargestellten Eingangswandler EW sind Stummelfinger vorgesehen, die von den von der jeweils gegenüberliegenden Stromschiene ausgehenden Elektrodenfingern durch das Gap getrennt sind. Wie bereits in den Ausführungsformen gemäß der Figuren 1 und 2 ist auch hier die Teilspur TS2 mit wesentlich größerer Teilapertur ausgeführt als die Teilspur TS1. Entsprechend kann die zweite Teilspur TS2 als Hauptspur angesehen werden, deren Anregungsfunktion AF2 durch die Anregungsfunktion AF1 der ersten Teilspur TS1 nur noch modifiziert wird.

Die im dargestellten Eingangswandler EW verwendete Anregungsfunktion ist durch die Überlappung von mit einander gegenüberliegenden Stromschienen verbundener Elektrodenfinger gekennzeichnet. Das Überlappungsgebiet bildet mehrere Keulen aus, von denen vorzugsweise die größte Keule mit den größten Überlappungen in der Mitte des Wandlers angeordnet ist. An beiden Enden des Eingangswandlers EW sind nur noch geringe Überlappungen vorgesehen. Ebenso sind die Überlappungen in der wesentlich kleineren Teilspur TS1 relativ gering.

Als weiteres Detail sind die Gaps der größeren Teilspur TS2 in der Nähe der äußeren Stromschiene SS2 angeordnet. Da die mittlere Stromschiene SS_{M} in beiden Verschaltungszuständen mit dem Massepotenzial verbunden ist, hat dies zur Folge, dass die längeren Elektrodenfinger auf diese Weise mit dem Massepotenzial verbunden sind. Dies schirmt den Eingangswandler EW vom Ausgangswandler AW kapazitiv ab und vermindert das Übersprechen zwischen den beiden Wandlern. Den gleichen Zweck erfüllt die Abschirmstruktur ABS, die dafür eine Breite hat, die wesentlich über die Breite der Elektrodenfinger hinausgeht.

Mit einem ähnlich wie in Figur 3 ausgebildeten Filter, dessen Eingangswandler EW in der Figur 3 nur ausschnittsweise dargestellt ist, lassen sich beispielsweise zwei Übertragungsfunktionen mit unterschiedlicher Bandbreite von 6 bzw. 7 MHz realisieren, wie sie beispielsweise bei Fernsehgeräten zum Umschalten zwischen dem UHF- und dem VHF-Bereich benötigt werden.

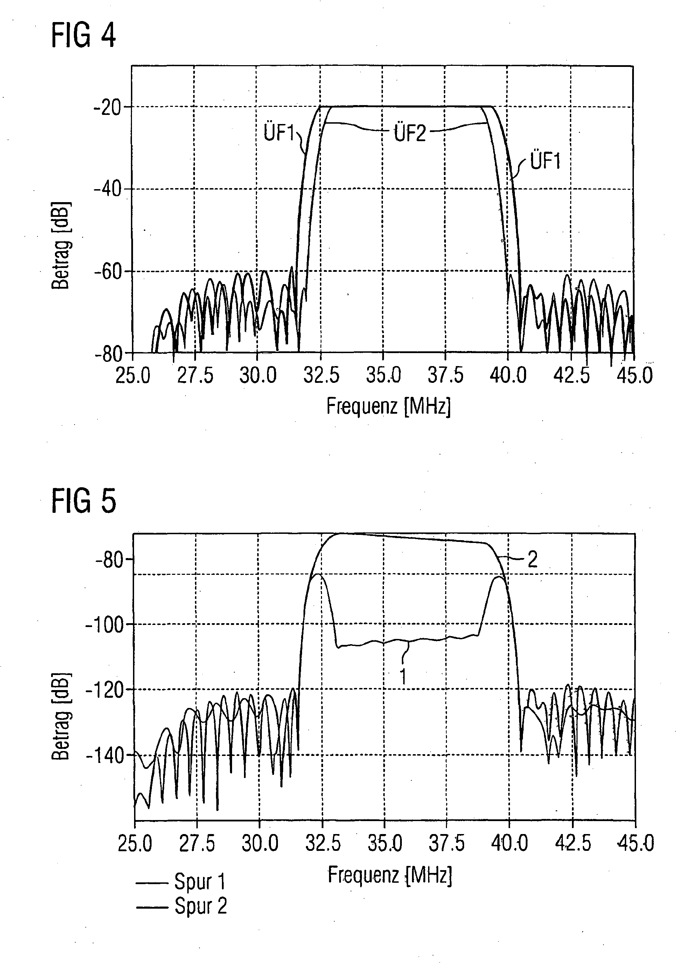

Figur 4 zeigt die Übertragungsfunktionen ÜF1 und ÜF2 eines derart ausgebildeten erfindungsgemäßen Filters anhand ihres S-Parameters S21. Die beiden Verschaltungszustände des Filters werden erreicht, indem die mittlere Stromschiene SSₘ mit Masse verbunden wird, während die beiden äußeren Stromschienen SS1, SS2 entweder auf dem gleichen "heißen" Potenzial liegen oder indem die beiden äußeren Stromschienen mit einem differenziellen Signal verbunden werden.

Die Figur 4 zeigt, dass auf diese Weise jeweils ein Passband mit steilen Flanken von geringer Welligkeit erzielt wird und dass sich die beiden Übertragungsfunktionen ÜF1, ÜF2 lediglich durch die Bandbreite, also das breitere Passband, unterscheiden.

In Figur 5 stellen die beiden Kurven 1 und 2 den Transferleitwert für die beiden Teilspuren TS1, TS2 getrennt voneinander dar. Aus dieser Darstellung lässt sich gut erkennen, wie die unterschiedlichen Bandbreiten durch Addition oder Subtraktion der beiden Kurven 1, 2 erhalten werden.

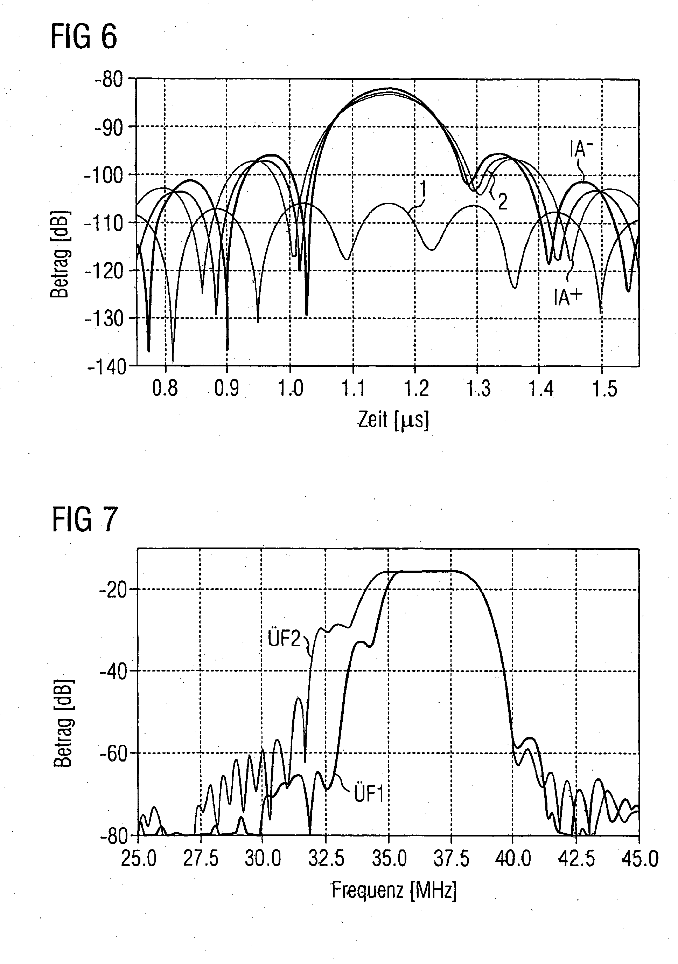

Figur 6 zeigt die Impulsantworten des erfindungsgemäßen Filters für beide Übertragungsfunktionen und für jede Teilspur. Die Kurven 1 und 2 für die Impulsantwort der entsprechenden isolierten Teilspuren TS1, TS2, die durch Addition die Impulsantwort IA⁺ bzw. durch Subtraktion die Impulsantwort IA⁻ ergeben. Aus dieser Figur wird auch klar, wie die Anregungsfunktion der als Korrekturspur dienenden ersten Teilspur TS1 anzulegen ist bzw. welche Anregungsfunktion zu realisieren ist.

In einem weiteren Ausführungsbeispiel wird ein IntercarrierFilter auf erfindungsgemäße Weise konstruiert, welches sich sowohl in der Bandbreite der Übertragungsfunktion als auch in der Bandbreite und Lage der Inter-Carrier-Stufe, die zur Übertragung der Tonsignale verwendet wird, unterscheidet.

Figur 7 zeigt die Übertragungsfunktionen ÜF1, ÜF2 eines erfindungsgemäßen Inter-Carrier-Filters, die sich durch unterschiedliche Verschaltung der beiden Teilspuren TS1, TS2 dieses weiteren Ausführungsbeispiels ergeben. Das breite Passband mit der relativ geringen Einfügedämpfung wird zur Übertragung von Bilddaten bzw. zur Ausfilterung der Bilddaten aus dem empfangenen Eingangssignal verwendet, während jeweils die linke dem Passband benachbarte Schulter einem weiteren Passband mit relativ höherer Einfügedämpfung entspricht, in dem die Toninformation des Eingangssignal übertragen wird bzw. vom Filter aus dem Eingangssignal herausgefiltert wird.

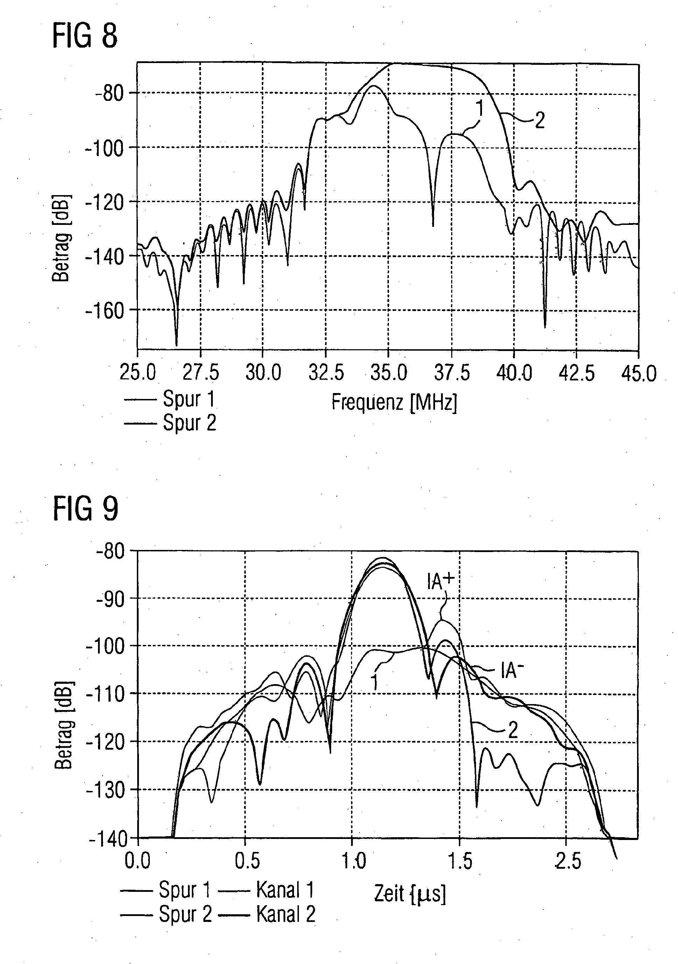

In Figur 8 ist der Y21-Wert getrennt für die beiden Teilspuren dargestellt;

In Figur 9 sind Impulsantworten für die Teilspuren und die beiden Schaltzustände des Filters dargestellt. Die Kurven 1 und 2 entsprechen den Impulsantworten der beiden entsprechenden Teilspuren TS1, TS2, die durch Addition die Impulsantwort IA⁺ im ersten Schaltungszustand des Filters und durch Subtraktion die Impulsantwort IA⁻ entsprechend dem zweiten Schaltungszustand des Filters wiedergeben.

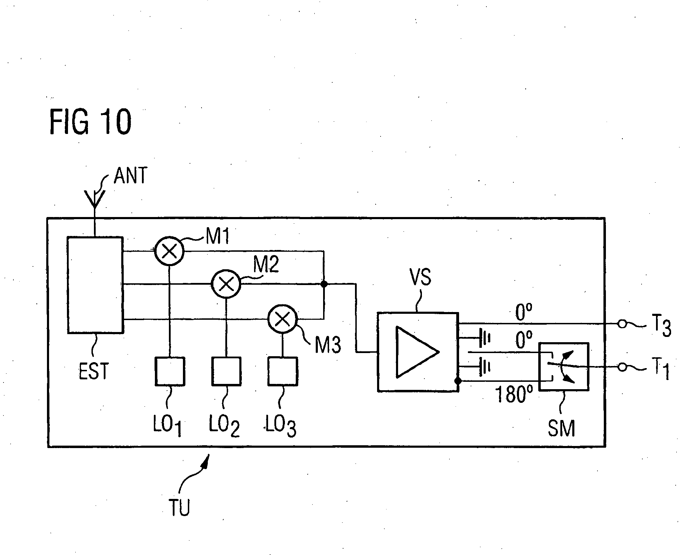

Figur 10 zeigt in schematischer Darstellung eine mögliche Ausführung eines Tuners, wie er für die Erfindung eingesetzt werden kann bzw. wie er zum Treiben eines erfindungsgemäßen Filters geeignet ist. Das ungefilterte Signal wird am Eingang ANT angelegt, der beispielsweise mit einer Antenne oder einem Fernsehkabel verbunden werden kann. In einer Eingangsstufe EST erfährt das Signal eine Vorfilterung und wird am Ausgang der Eingangsstufe in drei Kanäle aufgesplittet. Jeder dieser Kanäle wird einem Mischer M1, M2 bzw. M3 zugeführt, in dem das jeweilige Signal mit einer LO-Frequenz, die von einem lokalen Oszillator LO1 bis LO3 geliefert wird, auf eine Zwischenfrequenz umgesetzt wird.

An der Ausgangsseite der Mischer M1 bis M3 werden die drei Pfade wieder zusammengeführt und einer Verstärkerstufe VS zugeführt. Am Ausgang der Verstärkerstufe sind drei Ausgänge vorgesehen, wobei zwei der Ausgänge identisch sind (Phase 0°). Der dritte Ausgang liefert ein zu den beiden anderen Ausgängen differenzielles Signal(Phase 180°). Die Verstärkerstufe wird mit einem Schaltmittel SM verbunden, welches zwei Schaltstufen aufweist und dabei den mittleren Anschluss T1 am Ausgang des Tuners TU wahlweise mit einem der beiden doppelt vorhandenen heißen Ausgänge (Phase 0°) oder dessen symmetrischen Gegenpart (Phase 180°) verbindet. Am Anschluss T3 liegt wieder ein Signal mit Phase 0° an.

Für einen Gleichtaktbetrieb (erster Schaltungszustand) ist die Schalterposition im Schaltmittel so, dass an T1 und T3 das gleiche Potenzial anliegt (zweimal Phase 0°). In der Schalterposition 2 liegt wie vorher am Anschluss T3 Phase 0° an, am Anschluss T1 dagegen das für den Gegentaktbetrieb erforderliche symmetrische Signal mit Phase 180° an.

Schaltmittel SM und Verstärkerstufe VS können in einem einzigen IC verwirklicht sein. Vorzugsweise ist der gesamte Tuner TU auf einem Board ausgebildet und in einer noch höheren Integrationsstufe als Tunermodul realisiert.

Der Schalter bzw. das Schaltmittel SM wird durch ein Register im IC kontrolliert. Am IC gibt es weiterhin nur zwei Pins zur Verbindung mit dem SAW Filter sowie Massepins für Ausgleichsströme.

Zum Betreiben eines erfindungsgemäßen Filters werden die Ausgänge des Tuners T1 und T3 mit den äußeren Stromschienen SS1, SS2 eines erfindungsgemäßen SAW Filters verbunden, während die mittlere Stromschiene SS_{M} mit Masse verbunden wird. Dies kann beispielsweise mit Hilfe von Bonddrähten erfolgen, die zum entsprechenden Anschlusspad des Filters geführt werden.

Obwohl die Erfindung nur anhand weniger Ausführungsbeispiele erläutert wurde, ist sie nicht auf diese beschränkt. Ein erfindungsgemäßes Filter kann vorteilhaft in Gleich- und Gegentaktbetrieb angesteuert werden, wobei die beiden Ausgänge einer differenziellen Verstärkerstufe für den Gegentaktbetrieb genutzt werden können. Möglich ist es jedoch auch, die beiden Teilspuren TS1, TS2 eines erfindungsgemäßen Eingangswandlers jeweils mit einem unsymmetrischen Signal gegen Masse zu verschalten, wobei die beiden Übertragungsfunktionen durch parallele oder antiparallele Verschaltung der beiden Spuren realisiert werden können. Diese Ausführung erfordert jedoch voneinander getrennt ausgebildete Teilspuren, wie sie etwa in Figur 2 dargestellt sind.

Im Rahmen der Erfindung liegt es auch, beliebige Übertragungsfunktionen durch die entsprechend ausgestalteten Anregungsfunktionen innerhalb der beiden Teilspuren zu realisieren. Das Verhältnis der beiden Teilaperturen TA1, TA2 zueinander wird dabei in Abhängigkeit vom Unterschied zwischen den beiden gewünschten Übertragungsfunktionen gewählt. Je stärker sich die beiden Übertragungsfunktionen unterscheiden, desto größer muss die Teilapertur TA1 der Korrekturspur gewählt werden. Für kleine Unterschiede genügt es, relativ zur Hauptspur bzw. zur Teilspur TS2 eine relativ kleine Apertur für die Korrekturspur, die Teilspur TS1, zu wählen.

Je unterschiedlicher die beiden Teilspuren sind, desto stärker kann sich der am Massepotenzial anliegende Sammelstrom verändern. Das Tuner-Design bzw. die Verstärkerstufe eines passenden Tuners ist daher stets so auszulegen, dass sie die erforderlichen Ströme für den Eingangswandler eines erfindungsgemäßen Filters sowohl im Gleichtakt- als auch im Gegentaktbetrieb betreiben kann. Dies ist wichtig, da im Gegentaktbetrieb ein Teil des über die Masseschiene abfließenden Stroms kompensiert wird, während er im Gleichtaktbetrieb komplett über die Masseschiene bzw. die mittlere Stromschiene SS_{M} abfließt.

Ein erfindungsgemäßer Tuner kann außerdem weitere Komponenten umfassen, die jedoch für die notwendigen Grundfunktionen nicht entscheidend sind. Ein erfindungsgemäßes Filter kann Wandler unterschiedlichster Länge und unterschiedlichster Fingerstruktur aufweisen. Es ist nicht erforderlich, dass die Elektrodenfinger alle die gleiche Fingerperiode aufweisen. Vielmehr ist es möglich, dass innerhalb des Eingangswandlers unterschiedliche Fingerabstände realisiert sind, um die entsprechende Anregungsfunktion besser anzunähern.

### Bezugszeichenliste

- EW: Eingangswandler.
- AW: Ausgangswandler
- ÜF: Übertragungsfunktion
- TS1,TS2: Teilspur
- GA: Apertur
- TA1,TA2: Teilapertur
- TS1,TS2: Teilspur
- AF1, AF2: erste bzw. zweite Anregungsfunktion
- SS_{1,2,m}: Stromschienen
- ABS: Abschirmstruktur
- EST: Eingangsstufe
- M: Mischer
- VS: Verstärkerstufe
- SM: Schaltmittel
- ANT: Tunereingang
- TU: Tuner
- T1-T3: Tunerausgänge
- LO: Lokaler Oszillator

## Patentansprüche

1. Schaltbare Filtervorrichtung
mit einem SAW Filter mit zwei unterschiedlichen nutzbaren Übertragungsfunktionen,
- mit einem Eingangswandler (EW), der zwei Teilwandler umfasst,
- mit einer ersten akustischen Teilspur (TS1), die gewichtete Elektrodenfinger umfasst und eine ersten Apertur (TA1) aufweist
- mit einer zweiten akustischen Teilspur (TS2), die gewichtete Elektrodenfinger umfasst und mit eine zweite Apertur (TA2) aufweist
- mit einem Ausgangswandler (AW), dessen Apertur (GA) zumindest der Summe aus erster und zweiter Apertur entspricht, und mit einem Tuner (TU), wobei der Tuner aufweist eine Eingangsstufe (EST), ausgebildet zum Empfang eines ungefilterten Eingangssignals,
- einen Mischer (M1, M2, M3), die das Eingangssignal auf eine Zwischenfrequenz umsetzt,
- eine Verstärkerstufe (US), die als Treiber für das SAW Filter ausgebildet ist und sowohl ein differentielles symmetrisches Ausgangssignal als auch ein unsymmetrisches Ausgangssignal liefern kann,
- Schaltmittel (SM), die die beiden Teilspuren des SAW Filters wahlweise parallel mit dem unsymmetrischen Ausgangssignal oder antiparallel so schalten können, dass jede Teilspur mit jeweils einem Teilpotential des differentiellen Ausgangssignals gegen Masse geschaltet ist, wobei durch die beiden unterschiedlichen Verschaltungen der beiden Teilspuren eine erste und eine zweite Übertragungsfunktion (ÜF1, ÜF2) realisiert werden.

2. Filtervorrichtung nach Anspruch 1,
bei der bei dem sich die Eingangsimpedanzen der beiden Verschaltungen nicht oder nur unwesentlich unterscheiden.

3. Filtervorrichtung nach Anspruch 1 oder 2,
bei dem die beiden Teilspuren des Eingangswandlers (EW) eine gemeinsame, mittlere Stromschiene aufweisen, die mit Masse verbunden ist.

4. Filtervorrichtung nach einem der Ansprüche 1 bis 3,
bei dem der Eingangswandler (EW) eine Splitfingeranordnung aufweist.

5. Filtervorrichtung nach einem der Ansprüche 1 bis 4,
bei dem im Eingangswandlers (EW)eine Wichtung so ausgeführt ist, dass an dem zum Ausgangswandler (AW) gerichteten Ende kürzere Überlappungen vorgesehen sind als in der Mitte des Eingangswandlers, und bei dem Elektrodenfinger, die mit der mit Masse beaufschlagten Stromschiene verbunden sind, länger sind als die korrespondierenden, mit der mit Signal beaufschlagten Stromschiene verbundenen Elektrodenfinger.

6. Filtervorrichtung nach einem der Ansprüche 1 bis 5,
bei dem der Ausgangswandler (AW) gewichtet ist.

7. Filtervorrichtung nach einem der Ansprüche 1 bis 6,
bei dem der Ausgangswandler (AW) Splitfinger aufweist oder SPUDT-Zellen enthält.

8. Filtervorrichtung nach einem der Ansprüche 1 bis 5,
bei dem der Ausgangswandler (AW) ein Normalfingerwandler ist und weniger Elektrodenfinger als der Eingangswandler (EW) aufweist.

9. Filtervorrichtung nach einem der Ansprüche 1 bis 8,
bei dem zwischen Eingangswandler (EW) und Ausgangswandler (AW) eine Abschirmstruktur (ABS) angeordnet ist.

10. Filtervorrichtung nach Anspruch 9,
bei dem die Abschirmstruktur (ABS) ein Metallisierungsstreifen ist, der schräg über beide Teilaperturen (TA) verläuft und eine größere Breite als die Elektrodenfinger des Eingangswandlers (EW) aufweist.

11. Filtervorrichtung nach einem der Ansprüche 1 bis 10,
bei dem der Abstand der Stromschienen (SS) der beiden Teilspuren (TS1, TS2) am ausgangseitigen Ende des Eingangswandlers (EW) über 2 bis 4 endständige Elektrodenfinger stufenförmig gegenüber dem übrigen Wandler verkürzt ist.

12. Filtervorrichtung nach einem der Ansprüche 1 bis 11,
in dem zwei Übertragungsfunktionen mit jeweils einem Passband realisiert sind, die sich bezüglich der Bandbreite unterscheiden.

13. Filtervorrichtung nach einem der Ansprüche 1 bis 12,
ausgebildet als Intercarrierfilter für zwei unterschiedliche Standards.

14. Filtervorrichtung nach einem der Ansprüche 1 bis 13,
bei der die Verstärkerstufe und die Schaltmittel auf einem IC integriert sind.

15. Verfahren zum Betreiben einer Filtervorrichtung nach einem der Ansprüche 1 bis 14, bei dem das SAW Filter zwischen zwei unterschiedlichen Übertragungsfunktionen umschaltbar ist,
- bei dem in jeder der beiden Teilspuren durch Wichtung eine erste bzw. zweite Anregungsfunktion AF1, AF2 realisiert ist,
- mit einer Verstärkerstufe (US), die als Treiber für das SAW Filter ausgebildet ist und sowohl ein differentielles symmetrisches Ausgangssignal als auch ein unsymmetrisches Ausgangssignal liefern kann,
- bei dem mit Hilfe von Schaltmitteln (SM) in der Filtervorrichtung zwischen einer ersten und eine zweiten Übertragungsfunktion ÜF1, ÜF2 umgeschaltet wird,
- wobei für die erste Übertragungsfunktion ÜF1 die Teilspuren (TS1, TS2) des SAW Filters parallel mit dem unsymmetrischen Ausgangssignals und Masse verbunden werden und
- wobei für die zweite Übertragungsfunktion ÜF2 die Teilspuren (TS1, TS2) des SAW Filters antiparallel jeweils mit einem Potential des differentiellen symmetrischen Ausgangssignals und Masse verbunden werden.

## Claims

1. Switchable filter device
comprising a SAW filter having two different usable transfer functions,
- comprising an input transducer (EW), which comprises two partial transducers,
- comprising a first acoustic partial track (TS1), which comprises weighted electrode fingers and has a first aperture (TA1),
- comprising a second acoustic partial track (TS2) which comprises weighted electrode fingers and concomitantly has a second aperture (TA2),
- comprising an output transducer (AW), the aperture (GA) of which corresponds at least to the sum of the first and second apertures, and comprising a tuner (TU), wherein the tuner has
- an input stage (EST), designed for receiving an unfiltered input signal,
- a mixer (M1, M2, M3), which converts the input signal to an intermediate frequency,
- an amplifier stage (VS), which is designed as a driver for the SAW filter and can supply both a differential balanced output signal and an unbalanced output signal,
- switching means (SM), which can switch the two partial tracks of the SAW filter optionally in parallel with the unbalanced output signal or in antiparallel in such a way that each partial track is switched relative to earth with in each case a partial potential of the differential output signal, wherein a first and a second transfer function (ÜF1, ÜF2) are realized by the two different interconnections of the two partial tracks.

2. Filter device according to Claim 1,
wherein the input impedances of the two interconnections do not differ, or differ only insignificantly.

3. Filter device according to Claim 1 or 2,
wherein the two partial tracks of the input transducer (EW) have a common, central busbar connected to earth.

4. Filter device according to any of Claims 1 to 3,
wherein the input transducer (EW) has a split-finger arrangement.

5. Filter device according to any of Claims 1 to 4,
wherein a weighting is implemented in the input transducer (EW) such that shorter overlaps are provided at the end directed towards the output transducer (AW) than in the centre of the input transducer, and wherein electrode fingers connected to the earthed busbar are longer than the corresponding electrode fingers connected to the busbar to which a signal is applied.

6. Filter device according to any of Claims 1 to 5,
wherein the output transducer (AW) is weighted.

7. Filter device according to any of Claims 1 to 6,
wherein the output transducer (AW) has split fingers or contains SPUDT cells.

8. Filter device according to any of Claims 1 to 5,
wherein the output transducer (AW) is a normal finger transducer and has fewer electrode fingers than the input transducer (EW).

9. Filter device according to any of Claims 1 to 8,
wherein a shielding structure (ABS) is arranged between input transducer (EW) and output transducer (AW).

10. Filter device according to Claim 9,
wherein the shielding structure (ABS) is a metallization strip which runs obliquely over both partial apertures (TA) and has a larger width than the electrode fingers of the input transducer (EW).

11. Filter device according to any of Claims 1 to 10,
wherein the distance between the busbars (SS) of the two partial tracks (TS1, TS2) at the output-side end of the input transducer (EW) is shortened relative to the rest of the transducer in a stepped manner over 2 to 4 terminal electrode fingers.

12. Filter device according to any of Claims 1 to 11,
in which two transfer functions each having a passband are realized, which differ with regard to the bandwidth.

13. Filter device according to any of Claims 1 to 12,
designed as an intercarrier filter for two different standards.

14. Filter device according to any of Claims 1 to 13,
wherein the amplifier stage and the switching means are integrated on an IC.

15. Method for operating a filter device according to any of Claims 1 to 14, wherein the SAW filter can be switched over between two different transfer functions,
- wherein, in each of the two partial tracks, a first and respectively second excitation function AF1, AF2 is realized by weighting,
- with an amplifier stage (VS), which is designed as a driver for the SAW filter and can supply both a differential balanced output signal and an unbalanced output signal,
- wherein a switch-over between a first and a second transfer function ÜF1, ÜF2 is effected with the aid of switching means (SM) in the filter device,
- wherein, for the first transfer function ÜF1, the partial tracks (TS1, TS2) of the SAW filter are connected in parallel to the unbalanced output signal and earth, and
- wherein, for the second transfer function ÜF2, the partial tracks (TS1, TS2) of the SAW filter are connected in antiparallel in each case to a potential of the differential balanced output signal and earth.

## Revendications

1. Dispositif commutable de filtrage présentant
un filtre SAW doté de deux fonctions de transfert utilisables de manières différentes,
un convertisseur d'entrée (EW) qui comporte deux convertisseurs partiels,
une première voie acoustique partielle (TS1) qui comporte des doigts d'électrode pondérés et présente une première ouverture (TA1),
une deuxième voie acoustique partielle (TS2) qui comporte des doigts d'électrode pondérés et présente une deuxième ouverture (TA2),
un convertisseur de sortie (AW) dont l'ouverture (GA) correspond au moins à la somme de la première et de la deuxième ouverture,
un accordeur (TU), l'accordeur présentant :
un étage d'entrée (EST) configuré pour recevoir un signal d'entrée non filtré,
un mélangeur (M1, M2, M3) qui convertit le signal d'entrée à une fréquence intermédiaire,
un étage d'amplification (VS) configuré comme pilote pour le filtre SAW et apte à délivrer à la fois un signal de sortie différentiel symétrique et un signal de sortie asymétrique,
des moyens de commutation (SM) qui peuvent commuter les deux voies partielles du filtre SAW sélectivement de manière parallèle ou de manière antiparallèle par rapport au signal asymétrique de sortie de telle sorte que chaque voie partielle soit raccordée à la masse à un potentiel partiel du signal différentiel de sortie, les deux raccordements différents des deux voies partielles permettant de réaliser une première et une deuxième fonction de transfert (ÜF1, ÜF2).

2. Dispositif de filtrage selon la revendication 1, dans lequel les impédances d'entrée des deux raccordements ne sont pas différentes ou ne le sont que de manière négligeable.

3. Dispositif de filtrage selon les revendications 1 ou 2, dans lequel les deux voies partielles du convertisseur d'entrée (EW) présentent un rail de courant central commun raccordé à la masse.

4. Dispositif de filtrage selon l'une des revendications 1 à 3, dans lequel le convertisseur d'entrée (EW) présente un ensemble de doigts diviseurs.

5. Dispositif de filtrage selon l'une des revendications 1 à 4, dans lequel une pondération est réalisée dans le convertisseur d'entrée (EW) de telle sorte que des superpositions plus courtes sont prévues à l'extrémité orientée vers le convertisseur de sortie (AW) qu'au milieu du convertisseur d'entrée et dans lequel les doigts d'électrode raccordés au rail de courant appliqué à la masse sont plus longs que les doigts d'électrode correspondants reliés au rail de courant sur lequel est appliqué le signal.

6. Dispositif de filtrage selon l'une des revendications 1 à 5, dans lequel le convertisseur de sortie (AW) est pondéré.

7. Dispositif de filtrage selon l'une des revendications 1 à 6, dans lequel le convertisseur de sortie (AW) présente des doigts diviseurs ou contient des cellules SPUDT.

8. Dispositif de filtrage selon l'une des revendications 1 à 5 dans lequel le convertisseur de sortie (AW) est un convertisseur à doigts normal et présente un plus petit nombre de doigts d'électrode que le convertisseur d'entrée (EW).

9. Dispositif de filtrage selon l'une des revendications 1 à 8, dans lequel une structure de blindage (ABS) est disposée entre le convertisseur d'entrée (EW) et le convertisseur de sortie (AW).

10. Dispositif de filtrage selon la revendication 9, dans lequel la structure de blindage (ABS) est un ruban métallisé qui s'étend obliquement à travers les deux ouvertures partielles (TA) et dont la largeur est plus grande que celle des doigts d'électrode du convertisseur d'entrée (EW).

11. Dispositif de filtrage selon l'une des revendications 1 à 10, dans lequel la distance entre les rails de courant (SS) des deux voies partielles (TS1, TS2) à l'extrémité de sortie du convertisseur d'entrée (EW) est raccourcie en gradins sur 2 à 4 doigts d'électrode terminaux par rapport à l'autre convertisseur.

12. Dispositif de filtrage selon l'une des revendications 1 à 11, dans lequel deux fonctions de transfert qui présentent chacune une bande passante sont réalisées et présentent des largeurs de bande différentes.

13. Dispositif de filtrage selon l'une des revendications 1 à 12, configuré comme filtre dit "Intercarrier" pour deux normes différentes.

14. Dispositif de filtrage selon l'une des revendications 1 à 13, dans lequel l'étage d'amplification et le moyen de commutation sont intégrés sur un IC.

15. Procédé de conduite d'un dispositif de filtrage selon l'une des revendications 1 à 14, dans lequel
le filtre SAW peut être commuté entre deux fonctions de transfert différentes,
une première et une deuxième fonction d'excitation AF1, AF2 sont réalisées par pondération dans chacune des deux voies partielles,
avec un étage d'amplification (VS) configuré comme pilote pour le filtre SAW et apte à délivrer à la fois un signal de sortie différentiel symétrique et un signal de sortie asymétrique,
une commutation est réalisée entre une première et une deuxième fonction de transfert ÜF1, ÜF2 à l'aide de moyens de commutation (SM) prévus dans le dispositif de filtrage,
pour la première fonction de transfert ÜF1, les voies partielles (TS1, TS2) du filtre SAW sont raccordées en parallèle au signal de sortie asymétrique et à la masse et
pour la deuxième fonction de transfert ÜF2, les voies partielles (TS1, Ts2) du filtre SAW sont raccordées de manière antiparallèle à un potentiel du signal de sortie différentiel symétrique et à la masse.
